# EUROPEAN PATENT APPLICATION

(11) **EP 2 535 440 A1**
(43) Date of publication of application: **19.12.2012**
(21) Application number: 12150564.8
(22) Date of filing: 10.01.2012
(51) Int. Cl.: C23C 16/458, C23C 16/455, C30B 25/16, C30B 29/40, C23C 16/52

(54) **Chemical vapor deposition apparatus**

(30) Priority: 16.06.2011 US 201113162416
(71) Applicant: Pinecone Energies, Inc., Taipei City 110 (TW)
(72) Inventor: Liu, Heng, Sunnyvale, CA 94087 (US); Yakovlev, Evgeny Vladimirovich, 129-3-128 St. Petersburg (RU)
(74) Representative: Reichert, Sabine

(57) **Abstract**

System and method for forming one or more materials. The system includes a susceptor component configured to rotate around a central axis, and a showerhead component that is located above the susceptor component and not in direct contact with the susceptor component. Additionally, the system includes one or more substrate holders located on the susceptor component and configured to rotate around the central axis and also rotate around corresponding holder axes respectively, and a central component. Moreover, the system includes one or more first inlets formed within the central component, one or more second inlets, and one or more third inlets formed within the showerhead component and located farther away from the central component than the one or more second inlets.

## Description

### 1. BACKGROUND OF THE INVENTION

The present invention is directed to methods and systems of forming semiconductor materials. More particularly, the invention provides a reaction system and related method for forming semiconductor materials. Merely by way of example, the invention has been applied to forming Group-III nitride materials. But it would be recognized that the invention has a much broader range of applicability.

Metal-organic chemical vapor deposition (MOCVD) has been widely used for fabricating epitaxial layers of Group-III nitride materials, such as aluminum nitride, gallium nitride, and/or indium nitride. The MOCVD system often is easy to use and suitable for mass production. Usually, one or more Group-III metal organic (MO) gases and one or more Group-V gases are used to form the Group-III nitride materials. For example, the one or more Group-III MO gases include TMG (e.g., TMGa, trimethylgallium, and/or (CH₃)₃Ga), TMA (e.g., trimethylaluminum and/or (CH₃)₃Al), and/or TMI (e.g., trimethylindium and/or ((CH₃)₃In). In another example, the one or more Group-V gases include ammonia (e.g., NH₃).

The ammonia gas often is used to supply nitrogen atoms, but the dissociation efficiency of ammonia depends on temperature. The higher is the temperature of ammonia, the higher its dissociation efficiency becomes. For example, at 800°C, the dissociation efficiency of ammonia is only about 10%, but at 900°C, the dissociation efficiency of ammonia rises to about 20%. In contrast, the Group-III MO gases usually start to dissociate at a lower temperature, such as at about 300 - 400°C.

After the ammonia gas and the Group-III MO gas disassociate, the solid Group-III nitride materials may be formed. It is often important to match the heating of the gases and the transport of the gases, so that the Group-III nitride materials do not formed too early or too late. For example, the Group-III nitride materials should not be deposited on surfaces of various components of the MOCVD system or discharged out of the MOCVD system with other byproducts. Instead, the Group-III nitride materials usually are preferably formed on substrate surfaces (e.g., wafer surfaces), in order to lower cleaning costs and reduce consumption of reaction materials.

Additionally, for different Group-III nitride materials (e.g., gallium nitride and indium nitride), their growth conditions to form epitaxial layers may differ significantly. For example, the growth temperature for gallium nitride is desired to be above 1000°C, and the growth temperature for indium nitride is desired to be below 650°C. In another example, to form indium-gallium nitride, the growth temperature is limited by the low desirable temperature for indium nitride in order to reduce dissociation between indium and nitrogen atoms. But at the low growth temperature, a large amount of ammonia often needs to be supplied in order to provide sufficient nitrogen atoms for chemical reactions. Usually, the nitrogen consumption for growing indium nitride is several times more than the nitrogen consumption for growing gallium nitride or aluminum nitride. The supply of nitrogen atoms can also be enhanced by raising the partial pressure of ammonia, but such high partial pressure can make the epitaxial layers less uniform and increase fabrication costs.

Hence it is highly desirable to improve techniques for forming Group-III nitride materials.

### 2. BRIEF SUMMARY OF THE INVENTION

The present invention is directed to methods and systems of forming semiconductor materials. More particularly, the invention provides a reaction system and related method for forming semiconductor materials. Merely by way of example, the invention has been applied to forming Group-III nitride materials. But it would be recognized that the invention has a much broader range of applicability.

According to one embodiment, a system for forming one or more materials includes a susceptor component configured to rotate around a central axis, and a showerhead component that is located above the susceptor component and not in direct contact with the susceptor component. Additionally, the system includes one or more substrate holders located on the susceptor component and configured to rotate around the central axis and also rotate around corresponding holder axes respectively, and a central component. Moreover, the system includes one or more first inlets formed within the central component, one or more second inlets, and one or more third inlets formed within the showerhead component and located farther away from the central component than the one or more second inlets. The one or more first inlets are further configured to provide one or more first gases at one or more first flow rates respectively to flow away from the central component, the one or more second inlets are configured to provide one or more second gases at one or more second flow rates respectively, and the one or more third inlets are configured to provide one or more third gases at one or more third flow rates respectively to flow away from the showerhead component towards the susceptor component. The system is further configured to adjust the one or more second flow rates separately from adjusting the one or more third flow rates.

According to another embodiment, a method for adjusting at least one growth rate for at least one Group III-nitride material includes providing a system for forming at least one Group-III nitride material. The system includes a central component, a susceptor component, and a showerhead component. The showerhead component is located above the susceptor component and not in direct contact with the susceptor component. The system further includes one or more first inlets formed within the central component, one or more second inlets, and one or more third inlets formed within the showerhead component and located farther away from the central component than the one or more second inlets. Additionally, the method includes selecting one or more ammonia flow rates of an ammonia gas for one or more of the one or more first inlets, the one or more second inlets, and the one or more third inlets, and selecting a first flow rate for a Group-III metal-organic gas through the one or more second inlets and a second flow rate for the Group-III metal-organic gas through the one or more third inlets, a sum of the first flow rate and the second flow rate being equal to a third flow rate. Moreover, the method includes determining a first growth rate of the Group-III nitride material as a first function of location if the Group-III metal-organic gas flows through only the one or more second inlets at the first flow rate based on at least information associated with the one or more ammonia flow rates, and determining a second growth rate of the Group-III nitride material as a second function of location if the Group-III metal-organic gas flows through only the one or more third inlets at the second flow rate based on at least information associated with the one or more ammonia flow rates. Also, the method includes determining a third growth rate of the Group-III nitride material as a third function of location by adding the first growth rate and the second growth rate, the third growth rate corresponding to the first flow rate through the one or more second inlets and the second flow rate through the one or more third inlets.

According to yet another embodiment, a method for adjusting at least one growth rate for at least one Group III-nitride material includes providing a system for forming at least one Group-III nitride material. The system includes a central component, a susceptor component, a showerhead component, and one or more substrate holders on the susceptor component. The showerhead component is located above the susceptor component and not in direct contact with the susceptor component. The system further includes one or more first inlets formed within the central component, one or more second inlets, and one or more third inlets formed within the showerhead component and located farther away from the central component than the one or more second inlets. Additionally, the method includes selecting one or more ammonia flow rates of an ammonia gas for one or more of the one or more first inlets, the one or more second inlets, and the one or more third inlets, determining a first growth rate of the Group-III nitride material as a first function of location if a Group-III metal-organic gas flows through only the one or more second inlets at a first flow rate based on at least information associated with the one or more ammonia flow rates, and determining a second growth rate of the Group-III nitride material as a second function of location if the Group-III metal-organic gas flows through only the one or more third inlets at the first flow rate based on at least information associated with the one or more ammonia flow rates. Moreover, the method includes selecting a second flow rate for the Group-III metal-organic gas through the one or more second inlets and a third flow rate for the Group-III metal-organic gas through the one or more third inlets, a sum of the second flow rate and the third flow rate being equal to the first flow rate, and determining a third growth rate of the Group-III nitride material as a third function of location by weighted addition of the first growth rate and the second growth rate based on at least information associated with the second flow rate and the third flow rate.

Many benefits are achieved by way of the present invention over conventional techniques. Certain embodiments of the present invention provide a reaction system for chemical vapor deposition (CVD) with reduced consumption of one or more gas materials. For example, using the reaction system, metal-organic chemical vapor deposition (MOCVD) is performed with reduced consumption of ammonia. Some embodiments of the present invention provide a reaction system for Group-III nitride formation (e.g., aluminum nitride, gallium nitride, and/or indium nitride) that can reduce costs and improve performance of the MOCVD process.

Depending upon embodiment, one or more of these benefits may be achieved. These benefits and various additional objects, features and advantages of the present invention can be fully appreciated with reference to the detailed description and accompanying drawings that follow.

### 3. BRIEF DESCRIPTION OF THE DRAWINGS

Figures 1(A) and (B) are simplified diagrams showing a reaction system for forming one or more Group-III nitride materials according to an embodiment of the present invention.

Figure 2 is a simplified diagram showing a method for adjusting one or more distributions of one or more growth rates for one or more Group-III nitride materials using the reaction system according to an embodiment of the present invention.

Figure 3 is a simplified diagram showing a temperature distribution of the reaction system according to one embodiment of the present invention.

Figure 4 shows growth rate of gallium nitride as functions of radial distance with rotation around the susceptor axis but without rotation around a holder axis according to an embodiment of the present invention.

Figure 5 shows growth rate of gallium nitride as functions of radial distance with rotation around the susceptor axis and also with rotation around a holder axis according to an embodiment of the present invention.

Figure 6 is a simplified diagram showing a comparison of growth rate of gallium nitride determined by superposition and by recalculation according to an embodiment of the present invention.

### 4. DETAILED DESCRIPTION OF THE INVENTION

The present invention is directed to methods and systems of forming semiconductor materials. More particularly, the invention provides a reaction system and related method for forming semiconductor materials. Merely by way of example, the invention has been applied to forming Group-III nitride materials. But it would be recognized that the invention has a much broader range of applicability.

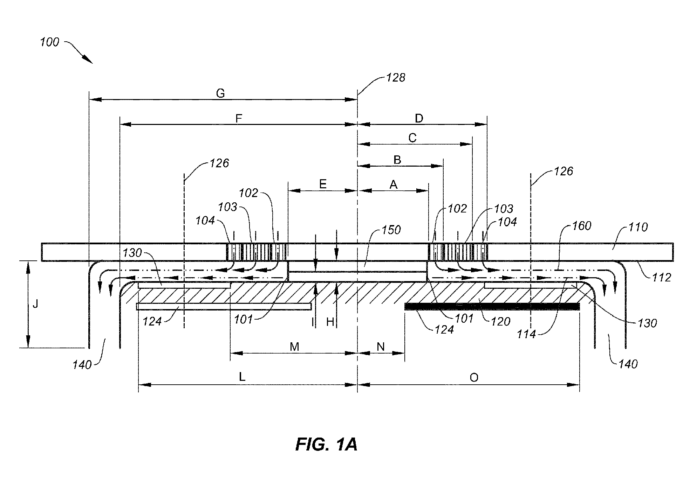

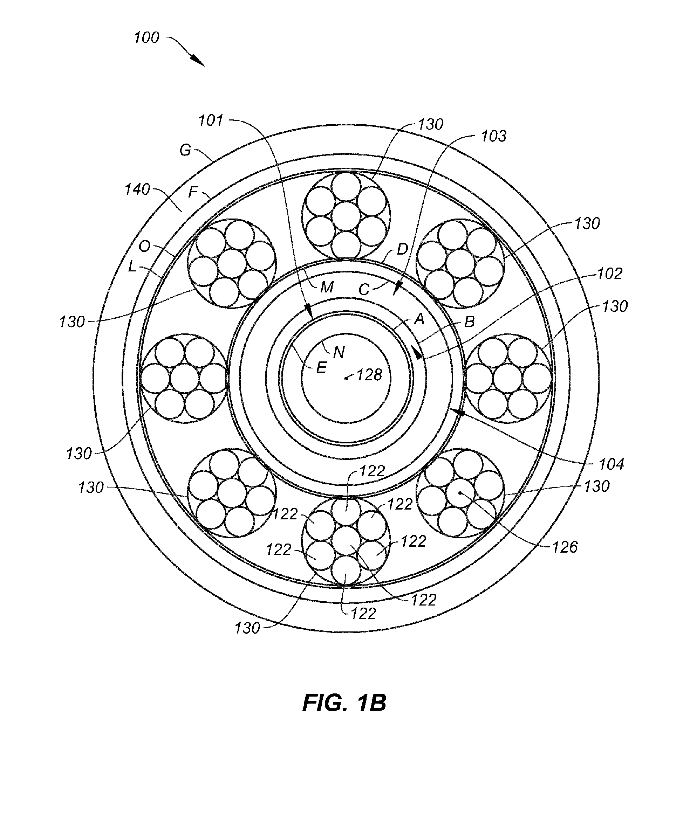

Figures 1(A) and (B) are simplified diagrams showing a reaction system for forming one or more Group-III nitride materials according to an embodiment of the present invention. These diagrams are merely examples, which should not unduly limit the scope of the claims. One of ordinary skill in the art would recognize many variations, alternatives, and modifications. For example, Figure 1(A) shows a side view of the reaction system 100, and Figure 1(B) shows a planar view of the reaction system 100. In another example, the reaction system 100 includes a showerhead component 110, a susceptor 120, inlets 101, 102, 103 and 104, one or more substrate holders 130, one or more heating devices 124, an outlet 140, and a central component 150. In yet another example, the central component 150, the showerhead component 110, the susceptor 120, and the one or more substrate holders 130 (e.g., located on the susceptor 120) form a reaction chamber 160 with the inlets 101, 102, 103 and 104 and the outlet 140. In yet another example, the one or more substrate holders 130 each are used to carry one or more substrates 122 (e.g., one or more wafers).

Although the above has been shown using a selected group of components for the system 100, there can be many alternatives, modifications, and variations. For example, some of the components may be expanded and/or combined. Other components may be inserted to those noted above. Depending upon the embodiment, the arrangement of components may be interchanged with others replaced.

According to one embodiment, the inlet 101 is formed within the central component 150 and configured to provide one or more gases in a direction that is substantially parallel to a surface 112 of the showerhead component 110. For example, the one or more gases flows (e.g., flows up) into the reaction chamber 160 near the center of the reaction chamber 160 and then flows through the inlet 101 outward radially, away from the center of the reaction chamber 160. According to another embodiment, the inlets 102, 103 and 104 are formed within the showerhead component 110 and configured to provide one or more gases in a direction that is substantially perpendicular to the surface 112.

For example, various kinds of gases are provided through the inlets 101, 102, 103 and 104 as shown in Table 1.

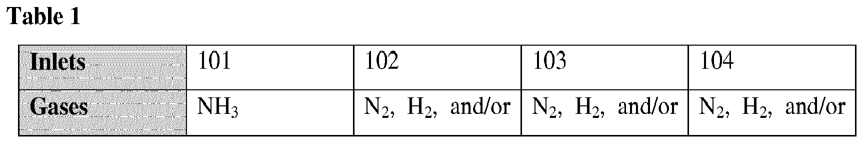

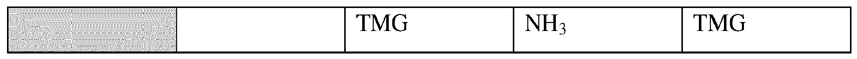

In one embodiment, the susceptor 120 is configured to rotate around a susceptor axis 128 (e.g., a central axis), and each of the one or more substrate holders 130 is configured to rotate around a corresponding holder axis 126. In another embodiment, the one or more substrate holders 130 can rotate, with the susceptor 120, around the susceptor axis 128, and also rotate around their corresponding holder axes 126. For example, the one or more substrates 122 on the same substrate holder 130 can rotate around the same holder axis 126.

According to one embodiment, the inlets 101, 102, 103 and 104, and the outlet 140 each have a circular configuration around the susceptor axis 128. According to another embodiment, the one or more substrate holders 130 (e.g., eight substrate holders 130) are arranged around the susceptor axis 128. For example, each of the one or more substrate holders 130 can carry several substrates 122 (e.g., seven substrates 122).

As shown in Figures 1(A) and (B), symbols A, B, C, D, E, F, G, H, I, J, L, M, N, and O represent various dimensions of the reaction system 100 according to some embodiments. In one embodiment,
(1) A represents the distance between the susceptor axis 128 and the inner edge of the inlet 102;
(2) B represents the distance between the susceptor axis 128 and the inner edge of the inlet 103;
(3) C represents the distance between the susceptor axis 128 and the inner edge of the inlet 104;
(4) D represents the distance between the susceptor axis 128 and the outer edge of the inlet 104;
(5) E represents the distance between the susceptor axis 128 and the inlet 101;
(6) F represents the distance between the susceptor axis 128 and the inner edge of the outlet 140;
(7) G represents the distance between the susceptor axis 128 and the outer edge of the outlet 140;
(8) H represents the distance between the surface 112 of the showerhead component 110 and a surface 114 of the susceptor 120;
(9) I represents the height of the inlet 101;
(10) J represents the distance between the surface 112 of the showerhead component 110 and the outlet 140;
(11) L represents the distance between the susceptor axis 128 and one or more outer edges of the one or more substrate holders 130 respectively;
(12) M represents the distance between the susceptor axis 128 and one or more inner edges of the one or more substrate holders 130 respectively;
(13) N represents the distance between the susceptor axis 128 and one or more inner edges of the one or more heating devices 124 respectively; and
(14) O represents the distance between the susceptor axis 128 and one or more outer edges of the one or more heating devices 124 respectively.

For example, L minus M is the diameter of the one or more substrate holders 130. In another example, the vertical size of the reaction chamber 160 (e.g., represented by H) is equal to or less than 20 mm, or is equal to or less than 15 mm. In yet another example, the vertical size of the inlet 101 (e.g., represented by I) is less than the vertical distance between the surface 112 of the showerhead component 110 and the surface 114 of the susceptor 120 (e.g., represented by H). In yet another example, some magnitudes of these dimensions are shown in Table 2 below.

**Table 2**

| **Dimension Symbol** | **Dimension Magnitude (unit: mm)** |
|---|---|
| A | 105 |
| B | 120 |
| C | 150 |
| D | 165 |
| E | 100 |
| F | 330 |
| G | 415 |
| H | 10 |
| I | 5 |
| J | 150 |
| L | 310 |
| M | 145 |
| N | 96 |
| O | 320 |

In one embodiment, the one or more substrate holders 130 are located on the susceptor 120. In another embodiment, the one or more heating devices 124 are located under the one or more substrate holders 130 respectively. For example, the one or more heating devices 124 extend toward the center of the reaction chamber 160 beyond the one or more substrate holders 130 respectively. In another example, the one or more heating devices 124 preheat the one or more gases from the inlets 101, 102, 103, and/or 104 before the one or more gases reach the one or more substrate holders 130.

As discussed above and further emphasized here, Figures 1(A) and (B) are merely examples, which should not unduly limit the scope of the claims. One of ordinary skill in the art would recognize many variations, alternatives, and modifications. For example, the inlet 102 is replaced by a plurality of inlets, and/or the inlet 104 is replaced by another plurality of inlets. In another example, the inlet 102 is formed within the central component 150 and configured to provide one or more gases in a direction that is substantially parallel to the surface 112 of the showerhead component 110.

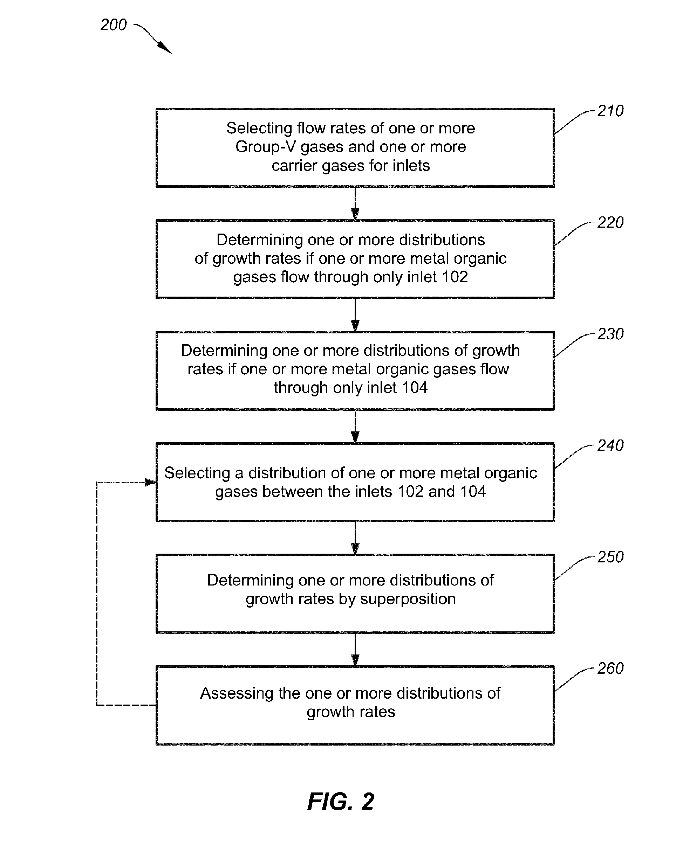

Figure 2 is a simplified diagram showing a method for adjusting one or more distributions of one or more growth rates for one or more Group-III nitride materials using the reaction system 100 according to an embodiment of the present invention. This diagram is merely an example, which should not unduly limit the scope of the claims. One of ordinary skill in the art would recognize many variations, alternatives, and modifications. The method 200 includes a process 210 for selecting flow rates of one or more Group-V gases and one or more carrier gases for inlets, a process 220 for determining one or more distributions of growth rates for one or more Group-III nitride materials if one or more metal organic gases flow through only inlet 102, a process 230 for determining one or more distributions of growth rates for one or more Group-III nitride materials if one or more metal organic gases flow through only inlet 104, a process 240 for selecting a distribution of one or more metal organic gases between the inlets 102 and 104, a process 250 for determining one or more distributions of growth rates for one or more Group-III nitride materials by superposition, and a process 260 for assessing the one or more distributions of growth rates for one or more Group-III nitride materials.

Although the above has been shown using a selected group of processes for the method 200, there can be many alternatives, modifications, and variations. For example, some of the processes may be expanded and/or combined. Other processes may be inserted to those noted above. Depending upon the embodiment, the sequence of processes may be interchanged with others replaced.

At the process 210, the flow rates of one or more Group-V gases and one or more carrier gases are selected for the inlets 101, 102, 103, and 104. For example, the one or more Group-V gases include the ammonia gas (e.g., NH₃). In another example, the one or more carrier gases include the hydrogen gas (e.g., H₂) and/or the nitrogen gas (e.g., N₂). In yet another example, the flow rates of the one or more Group-V gases (e.g., NH₃) and the one or more carrier gases (e.g., H₂ and N₂) for the inlets 101, 102, 103 and 104 are shown in Table 3 below.

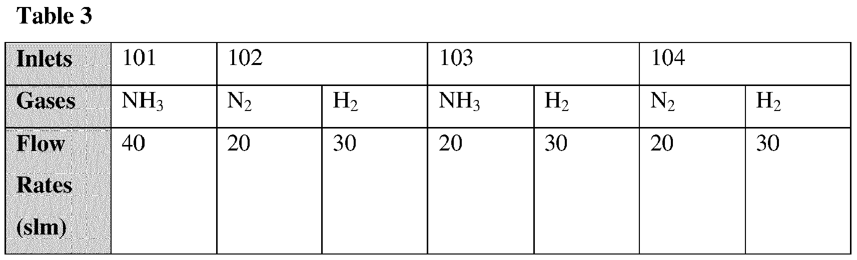

According to one embodiment, at the process 210, the total flow rate of the one or more metal organic gases (e.g., TMG) is also determined. For example, the total flow rate of the TMG gas is equal to 60 sccm. According to another embodiment, at the process 210, the pressure within the reaction chamber 160, the temperature of the heating devices 124, and the temperature of the showerhead component 110 are also determined. For example, the pressure within the reaction chamber 160, the temperature of the heating devices 124, and the temperature of the showerhead component 110 are shown in Table 4 below.

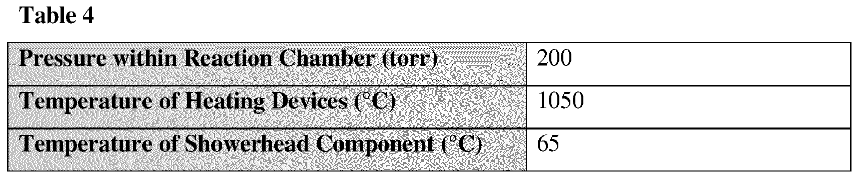

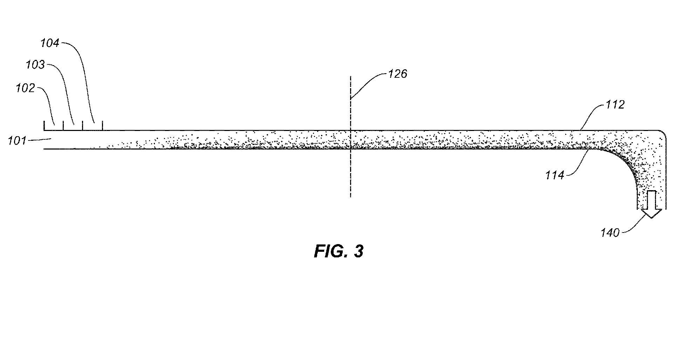

Figure 3 is a simplified diagram showing a temperature distribution of the reaction system 100 according to one embodiment of the present invention. This diagram is merely an example, which should not unduly limit the scope of the claims. One of ordinary skill in the art would recognize many variations, alternatives, and modifications. For example, the temperature of the heating devices 124 is set to 1050°C. In another example, the resulting temperature within the reaction chamber 160 is the highest in the proximity of the one or more substrate holders 130.

Returning to Figure 2, at the process 220, one or more distributions of growth rates for the one or more Group-III nitride materials are determined if the one or more metal organic gases flow through only the inlet 102. For example, the one or more distributions of growth rates are determined using the process conditions as shown in Tables 3 and 4 above and in Table 5 below.

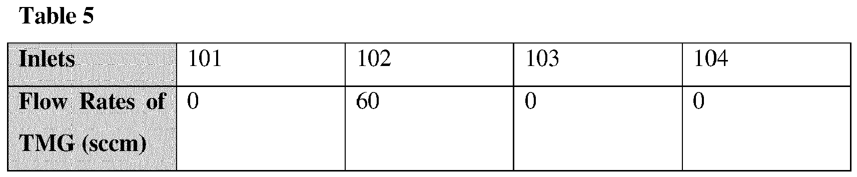

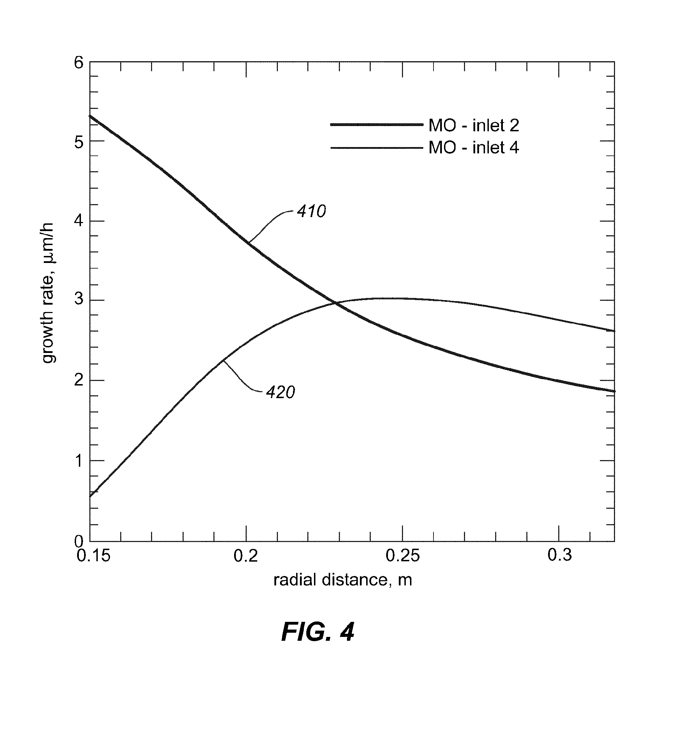

Figure 4 shows growth rate of gallium nitride as functions of radial distance with rotation around the susceptor axis 128 but without rotation around a holder axis 126 according to an embodiment of the present invention. This diagram is merely an example, which should not unduly limit the scope of the claims. One of ordinary skill in the art would recognize many variations, alternatives, and modifications. For example, the radial distance is measured from the susceptor axis 128. In another example, the growth rate is determined on the surface 114 of the susceptor 120. In yet another example, the substrate holder is assumed to extend from the radial distance of 0.15 m to the radial distance of 0.32 m, and the holder axis is located at the radial distance of 0.225 m. In yet another example, the substrate holder is assumed to rotate around the susceptor axis 128 at 30 rpm.

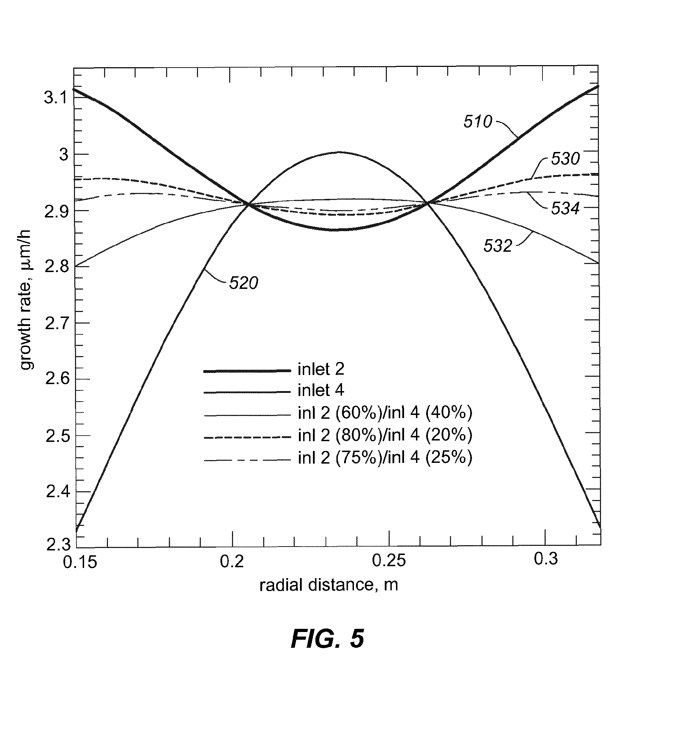

Figure 5 shows growth rate of gallium nitride as functions of radial distance with rotation around the susceptor axis 128 and also with rotation around a holder axis 126 according to an embodiment of the present invention. This diagram is merely an example, which should not unduly limit the scope of the claims. One of ordinary skill in the art would recognize many variations, alternatives, and modifications. For example, the radial distance is measured from the susceptor axis 128. In another example, the growth rate is determined on the surface 114 of the susceptor 120. In yet another example, the substrate holder is assumed to extend from the radial distance of 0.15 m to the radial distance of 0.32 m, and the holder axis is located at the radial distance of 0.225 m. In yet another example, the substrate holder is assumed to rotate around the susceptor axis 128 at 30 rpm, and also rotate around the holder axis 126 at 30 rpm.

According to one embodiment, as shown in Figure 4, the curve 410 represents the growth rate of gallium nitride as a function of radial distance under the process conditions as shown in Tables 3, 4 and 5 with rotation around the susceptor axis 128 but without rotation around a holder axis 126. According to another embodiment, as shown in Figure 5, the curve 510 represents the growth rate of gallium nitride as a function of radial distance under the process conditions as shown in Tables 3, 4 and 5 with rotation around the susceptor axis 128 and also with rotation around the holder axis 126.

Returning to Figure 2, at the process 230, one or more distributions of growth rates for the one or more Group-III nitride materials are determined if the one or more metal organic gases flow through only the inlet 104. For example, the one or more distributions of growth rates are determined using the process conditions as shown in Tables 3 and 4 above and in Table 6 below.

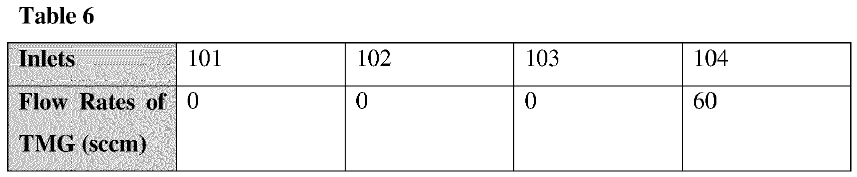

According to one embodiment, as shown in Figure 4, the curve 420 represents the growth rate of gallium nitride as a function of radial distance under the process conditions as shown in Tables 3, 4 and 6 with rotation around the susceptor axis 128 but without rotation around a holder axis 126. According to another embodiment, as shown in Figure 5, the curve 520 represents the growth rate of gallium nitride as a function of radial distance under the process conditions as shown in Tables 3, 4 and 6 with rotation around the susceptor axis 128 and also with rotation around the holder axis 126.

At the process 240, a distribution of the one or more metal organic gases between the inlets 102 and 104 is selected. For example, the flow rate of the TMG gas is allocated to the inlets 102 and 104 at various ratios (e.g., a% for inlet 102 and b% for inlet 104) with the total flow rates unchanged (e.g., a% + b% = 100%). In another example, the flow rates of the TMG gas through the inlets 102 and 104 are described in Table 7 below.

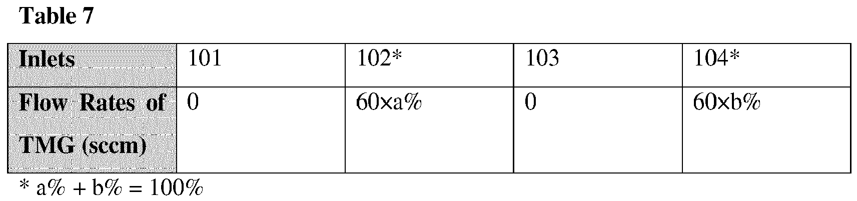

At the process 250, for the selected distribution of the one or more metal organic gases, one or more distributions of growth rates for the one or more Group-III nitride materials are determined by superposition. For example, the growth rate of gallium nitride is determined by adding a% multiplied by the growth rate previously determined at the process 220 and b% multiplied by the growth rate previously determined at the process 230.

In another example, one or more distributions of growth rates are determined using the process conditions as shown in Tables 3 and 4 above and in Table 8 below, and one or more distributions of growth rates are determined using the process conditions as shown in Tables 3 and 4 above and in Table 9 below. Then, one or more distributions of growth rates corresponding to Tables 3, 4 and 7 are determined by adding together the one or more distributions of growth rates corresponding to Tables 3, 4 and 8 and the one or more distributions of growth rates corresponding to Tables 3, 4 and 9.

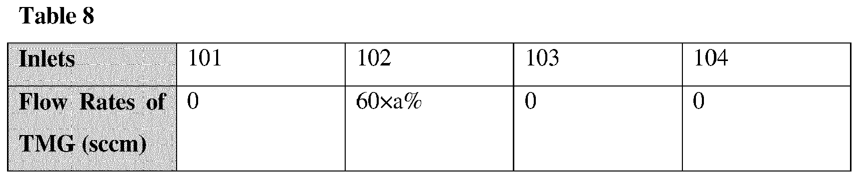

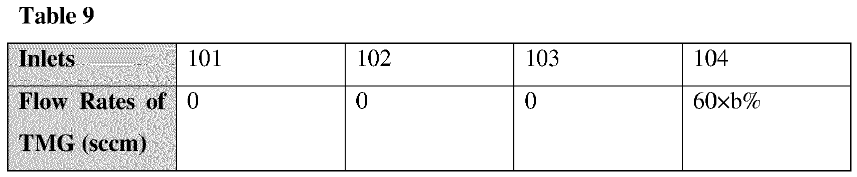

At the process 260, the one or more distributions of growth rates for the selected distribution of the one or more metal organic gases are assessed to determine whether the one or more distributions of growth rates satisfy one or more predetermined conditions (e.g., in terms of uniformity). For example, if the one or more predetermined conditions are not satisfied, the process 240 is performed. In another example, if the one or more predetermined conditions are satisfied, chemical vapor deposition is performed to form the one or more Group-III nitride materials (e.g., using the reaction system 100).

According to some embodiments, as shown in Figure 5, the curves 530, 532, and 534 each represent the growth rate of gallium nitride as a function of radial distance under the process conditions as shown in Tables 3, 4 and 7. For example, the curve 530 corresponds to a% equal to 80% and b% equal to 20%. In another example, the curve 532 corresponds to a% equal to 60% and b% equal to 40%. In yet another example, the curve 534 corresponds to a% equal to 75% and b% equal to 25%.

In one embodiment, as shown by the curve 532, insufficient supply of TMG through the inlet 102 results in a convex profile for the growth rate, and the curve 532 is determined to be unsatisfactory. In another embodiment, as shown by the curve 530, insufficient supply of TMG through the inlet 104 results in a concave profile for the growth rate, and the curve 530 is determined to be unsatisfactory. In yet another embodiment, as shown by the curve 534, a substantially uniform distribution of growth rate can be achieved for a% equal to 75% and b% equal to 25%, and the curve 534 is determined to be satisfactory. For example, by weighted addition, at a given radial distance, the growth rate for the curve 534 is the sum of the growth rate for the curve 510 multiplied by 75% and the growth rate for the curve 520 multiplied by 25%.

According to certain embodiments, in order to achieve a substantially uniform distribution of growth rate (e.g., as shown by the curve 534), it is important that the curve 510 is concave and the curve 520 is convex as shown in Figure 5. For example, if the peak of the growth rate of gallium nitride under the process conditions of Tables 3, 4 and 5 with rotation around the susceptor axis 128 but without rotation around a holder axis 126 lies outside the substrate holder (e.g., as shown by the curve 410 in Figure 4), the curve 510 is concave.

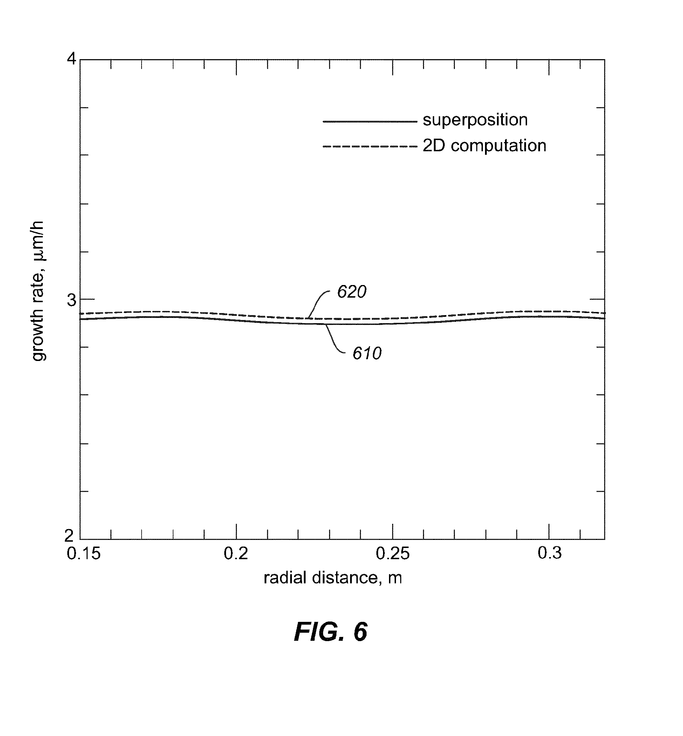

Figure 6 is a simplified diagram showing a comparison of growth rate of gallium nitride determined by superposition and by recalculation according to an embodiment of the present invention. This diagram is merely an example, which should not unduly limit the scope of the claims. One of ordinary skill in the art would recognize many variations, alternatives, and modifications. Curves 610 and 620 each represent the growth rate of gallium nitride as a function of radial distance under the process conditions as shown in Tables 3 and 4 above and Table 10 below.

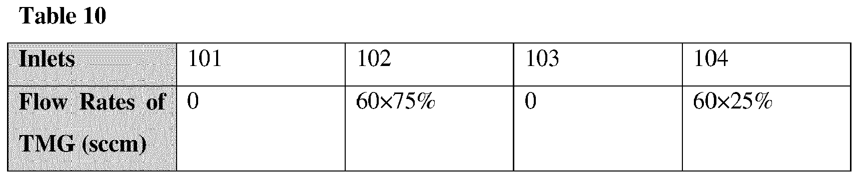

In one embodiment, the curve 610 is determined by weighted addition and hence is the same as the curve 534 in Figure 5. In another embodiment, the curve 620 is determined by recalculation without using growth rates of curves 510 and 520. As shown in Figure 6, the curve 610 is substantially the same as the curve 620; hence the weighted-addition technique is a reliable method in determining growth rates based on the distribution of flow rates between the inlets 102 and 104.

As discussed above and further emphasized here, Figure 2 is merely an example, which should not unduly limit the scope of the claims. One of ordinary skill in the art would recognize many variations, alternatives, and modifications. For example, the inlet 102 is replaced by a first plurality of inlets, and/or the inlet 104 is replaced by a second plurality of inlets. In another example, the process 210 is preceded by a process for providing the reaction system 100. In yet another example, the process 220 and/or the process 230 are skipped.

According to some embodiments, the weighted-addition technique used in the process 240 is reliable if one or more of the following conditions are satisfied:
(1) The total flow rate of one or more Group-III MO gases (e.g., TMG) is low in comparison with the total flow rate of the one or more Group-III MO gases (e.g., TMG), the one or more Group-V gases (e.g., ammonia), and the one or more carrier gases (e.g., hydrogen and nitrogen); and/or
(2) The growth of the one or more Group-III nitride materials (e.g., gallium nitride) proceeds under mass-transport limited conditions, without significant material loses due to particle formation during transport.

According to another embodiment, a system for forming one or more materials includes a susceptor component configured to rotate around a central axis, and a showerhead component that is located above the susceptor component and not in direct contact with the susceptor component. Additionally, the system includes one or more substrate holders located on the susceptor component and configured to rotate around the central axis and also rotate around corresponding holder axes respectively, and a central component. Moreover, the system includes one or more first inlets formed within the central component, one or more second inlets, and one or more third inlets formed within the showerhead component and located farther away from the central component than the one or more second inlets. The one or more first inlets are further configured to provide one or more first gases at one or more first flow rates respectively to flow away from the central component, the one or more second inlets are configured to provide one or more second gases at one or more second flow rates respectively, and the one or more third inlets are configured to provide one or more third gases at one or more third flow rates respectively to flow away from the showerhead component towards the susceptor component. The system is further configured to adjust the one or more second flow rates separately from adjusting the one or more third flow rates. For example, the system is implemented according to at least Figure 1(A) and/or Figure 1(B).

According to yet another embodiment, a method for adjusting at least one growth rate for at least one Group III-nitride material includes providing a system for forming at least one Group-III nitride material. The system includes a central component, a susceptor component, and a showerhead component. The showerhead component is located above the susceptor component and not in direct contact with the susceptor component. The system further includes one or more first inlets formed within the central component, one or more second inlets, and one or more third inlets formed within the showerhead component and located farther away from the central component than the one or more second inlets. Additionally, the method includes selecting one or more ammonia flow rates of an ammonia gas for one or more of the one or more first inlets, the one or more second inlets, and the one or more third inlets, and selecting a first flow rate for a Group-III metal-organic gas through the one or more second inlets and a second flow rate for the Group-III metal-organic gas through the one or more third inlets, a sum of the first flow rate and the second flow rate being equal to a third flow rate. Moreover, the method includes determining a first growth rate of the Group-III nitride material as a first function of location if the Group-III metal-organic gas flows through only the one or more second inlets at the first flow rate based on at least information associated with the one or more ammonia flow rates, and determining a second growth rate of the Group-III nitride material as a second function of location if the Group-III metal-organic gas flows through only the one or more third inlets at the second flow rate based on at least information associated with the one or more ammonia flow rates. Also, the method includes determining a third growth rate of the Group-III nitride material as a third function of location by adding the first growth rate and the second growth rate, the third growth rate corresponding to the first flow rate through the one or more second inlets and the second flow rate through the one or more third inlets. For example, the method is implemented according to at least Figure 2 and/or Figure 5.

According to yet another embodiment, a method for adjusting at least one growth rate for at least one Group III-nitride material includes providing a system for forming at least one Group-III nitride material. The system includes a central component, a susceptor component, a showerhead component, and one or more substrate holders on the susceptor component. The showerhead component is located above the susceptor component and not in direct contact with the susceptor component. The system further includes one or more first inlets formed within the central component, one or more second inlets, and one or more third inlets formed within the showerhead component and located farther away from the central component than the one or more second inlets. Additionally, the method includes selecting one or more ammonia flow rates of an ammonia gas for one or more of the one or more first inlets, the one or more second inlets, and the one or more third inlets, determining a first growth rate of the Group-III nitride material as a first function of location if a Group-III metal-organic gas flows through only the one or more second inlets at a first flow rate based on at least information associated with the one or more ammonia flow rates, and determining a second growth rate of the Group-III nitride material as a second function of location if the Group-III metal-organic gas flows through only the one or more third inlets at the first flow rate based on at least information associated with the one or more ammonia flow rates. Moreover, the method includes selecting a second flow rate for the Group-III metal-organic gas through the one or more second inlets and a third flow rate for the Group-III metal-organic gas through the one or more third inlets, a sum of the second flow rate and the third flow rate being equal to the first flow rate, and determining a third growth rate of the Group-III nitride material as a third function of location by weighted addition of the first growth rate and the second growth rate based on at least information associated with the second flow rate and the third flow rate. For example, the method is implemented according to at least Figure 2 and/or Figure 5.

Although specific embodiments of the present invention have been described, it will be understood by those of skill in the art that there are other embodiments that are equivalent to the described embodiments. For example, various embodiments and/or examples of the present invention can be combined. Accordingly, it is to be understood that the invention is not to be limited by the specific illustrated embodiments, but only by the scope of the appended claims.

## Claims

1. A system for forming one or more materials, the system comprising:
a susceptor component configured to rotate around a central axis;
a showerhead component located above the susceptor component, not in direct contact with the susceptor component;
one or more substrate holders located on the susceptor component and configured to rotate around the central axis and also rotate around corresponding holder axes respectively;
a central component;
one or more first inlets formed within the central component;
one or more second inlets; and
one or more third inlets formed within the showerhead component and located farther away from the central component than the one or more second inlets;
wherein:
the one or more first inlets are further configured to provide one or more first gases at one or more first flow rates respectively to flow away from the central component;
the one or more second inlets are configured to provide one or more second gases at one or more second flow rates respectively; and
the one or more third inlets are configured to provide one or more third gases at one or more third flow rates respectively to flow away from the showerhead component towards the susceptor component;
wherein the system is further configured to adjust the one or more second flow rates separately from adjusting the one or more third flow rates.

2. The system of claim 1, and further comprising one or more fourth inlets formed within the showerhead component and located farther away from the central component than the one or more second inlets and closer to the central component than the one or more third inlets.

3. The system of claim 2 wherein the one or more fourth inlets are configured to provide one or more fourth gases at one or more fourth flow rates respectively to flow away from the showerhead component towards the susceptor component.

4. The system of claim 3 wherein:
the one or more second gases include at least a first reactive gas that is not included in the one or more fourth gases; and
the one or more third gases include at least a second reactive gas that is not included in the one or more fourth gases.

5. The system of claim 4 wherein the first reactive gas and the second reactive gas are the same.

6. The system of claim 1, and further comprising one or more heating devices located below the one or more substrate holders respectively and extended closer to the central component than the one or more substrate holders respectively.

7. The system of claim 1 wherein the one or more second inlets are formed within the showerhead component and further configured to provide the one or more second gases at the one or more second flow rates respectively to flow away from the showerhead component towards the susceptor component.

8. The system of claim 1 wherein the one or more second inlets are formed within the central component and further configured to provide the one or more second gases at the one or more second flow rates respectively to flow away from the central component.

9. A method for adjusting at least one growth rate for at least one Group III-nitride material, the method comprising:
providing a system for forming at least one Group-III nitride material, the system including a central component, a susceptor component, and a showerhead component, the showerhead component being located above the susceptor component and not in direct contact with the susceptor component, the system further including one or more first inlets formed within the central component, one or more second inlets, and one or more third inlets formed within the showerhead component and located farther away from the central component than the one or more second inlets;
selecting one or more ammonia flow rates of an ammonia gas for one or more of the one or more first inlets, the one or more second inlets, and the one or more third inlets;
selecting a first flow rate for a Group-III metal-organic gas through the one or more second inlets and a second flow rate for the Group-III metal-organic gas through the one or more third inlets, a sum of the first flow rate and the second flow rate being equal to a third flow rate;
determining a first growth rate of the Group-III nitride material as a first function of location if the Group-III metal-organic gas flows through only the one or more second inlets at the first flow rate based on at least information associated with the one or more ammonia flow rates;
determining a second growth rate of the Group-III nitride material as a second function of location if the Group-III metal-organic gas flows through only the one or more third inlets at the second flow rate based on at least information associated with the one or more ammonia flow rates; and
determining a third growth rate of the Group-III nitride material as a third function of location by adding the first growth rate and the second growth rate, the third growth rate corresponding to the first flow rate through the one or more second inlets and the second flow rate through the one or more third inlets.

10. The method of claim 9 wherein the process for determining a first growth rate of the Group-III nitride material as a first function of location includes:
determining a fourth growth rate of the Group-III nitride material as a fourth function of location if the Group-III metal-organic gas flows through only the one or more second inlets at the third flow rate based on at least information associated with the one or more ammonia flow rates; and
multiplying the fourth growth rate by a first ratio equal to the first flow rate divided by the third flow rate.

11. The method of claim 9 wherein the process for determining a second growth rate of the Group-III nitride material as a second function of location includes:
determining a fifth growth rate of the Group-III nitride material as a fifth function of location if the Group-III metal-organic gas flows through only the one or more third inlets at the third flow rate based on at least information associated with the one or more ammonia flow rates; and
multiplying the fifth growth rate by a second ratio equal to the second flow rate divided by the third flow rate.

12. The method of claim 9, and further comprising:
processing information associated with the third growth rate of the Group-III nitride material as the third function of location;
determining whether the third growth rate satisfies one or more predetermined conditions which are associated with uniformity of the third growth rate, and
if the third growth rate is determined not to satisfy the one or more predetermined conditions,
selecting a fourth flow rate for the Group-III metal-organic gas through the one or more second inlets and a fifth flow rate for the Group-III metal-organic gas through the one or more third inlets, a sum of the fourth flow rate and the fifth flow rate being equal to the third flow rate; and
determining a fourth growth rate of the Group-III nitride material as a fourth function of location.

13. The method of claim 9, and further comprising if the third growth rate is determined to satisfy the one or more predetermined conditions, performing chemical vapor deposition of the Group III-nitride material based on at least information associated with the first flow rate and the second flow rate.

14. The method of claim 9 wherein the Group-III nitride material is selected from a group consisting of aluminum nitride, gallium nitride, and indium nitride.

15. The method of claim 9 wherein the Group-III metal-organic gas is selected from a group consisting of TMG, TMA and TMI.
